# EUROPEAN PATENT APPLICATION

(11) **EP 4 597 587 A1**
(43) Date of publication of application: **06.08.2025**
(21) Application number: 24186556.7
(22) Date of filing: 04.07.2024
(51) Int. Cl.: H01L 33/00, H01L 33/02, H01L 33/38

(54) **FLIP-CHIP LIGHT EMITTING DIODE AND MANUFACTURING METHOD THEREOF**

(30) Priority: 31.01.2024 TW 113103849
(71) Applicant: Taiwan-Asia Semiconductor Corporation, Hsinchu City 30078 (TW)
(72) Inventor: Hsieh, Po-Jen, 30078 Hsinchu City (TW); Cheng, Yu-Ling, 30078 Hsinchu City (TW); Wang, Tzu-Wen, 30078 Hsinchu City (TW); Chen, Ya-Chun, 30078 Hsinchu City (TW); Lin, Yi-Jen, 30078 Hsinchu City (TW)
(74) Representative: Michalski Hüttermann & Partner Patentanwälte mbB

(57) **Abstract**

A method for manufacturing a flip-chip light emitting diode is provided. The method includes the following steps: providing a first substrate; performing an epitaxial process to form a semiconductor structure on the first substrate, and the semiconductor structure includes a current conductive layer with a bonding surface and defines a first electrode projection area and a second electrode projection area; performing a diffusion process toward the bonding surface by a diffusion material to form at least one path area with a high doping concentration in the current conductive layer; performing a bonding process to bond a second substrate to the bonding surface; and removing the first substrate and forming a first electrode and a second electrode on a side of the semiconductor structure adjacent to the first substrate. A position of the first electrode corresponds to the first electrode projection area, and a position of the second electrode corresponds to the second electrode projection area.

## Description

### CROSS-REFERENCES TO RELATED APPLICATIONS

This application claims priority to Taiwan Patent Application No. 113103849 filed on January 31, 2024, which is hereby incorporated by reference in its entirety.

### BACKGROUND OF THE INVENTION

### Field of the Invention

The present invention relates to a flip-chip light emitting diode and a manufacturing method thereof, and in particular, to a flip-chip light emitting diode and a manufacturing method thereof that increase the light emitting area and reduce the current density.

### Descriptions of the Related Art

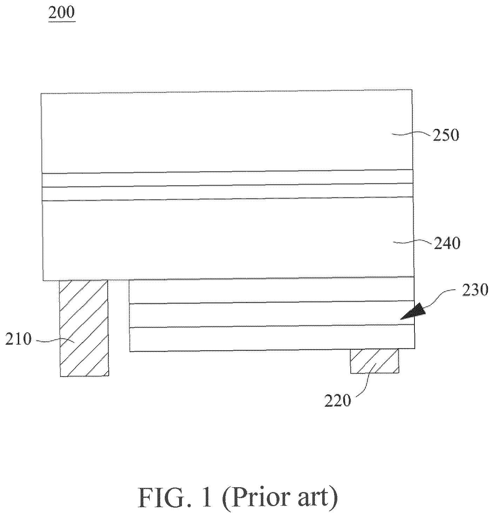

As shown in FIG. 1, the conventional flip-chip light emitting diode (LED) 200 mainly disposes the P metal electrode 210 and the N metal electrode 220 under the semiconductor light emitting structure 230 and the current conduction layer 240 (i.e. toward the bottom of the figure), and cover the transparent substrate 250 above the current conductive layer 240 so that after the P metal electrode 210 and the N metal electrode 220 are conductive, current can flow through the current conductive layer 240 and drive the semiconductor light emitting structure 230 to emit light which finally passes through the transparent substrate 250 for a luminous effect.

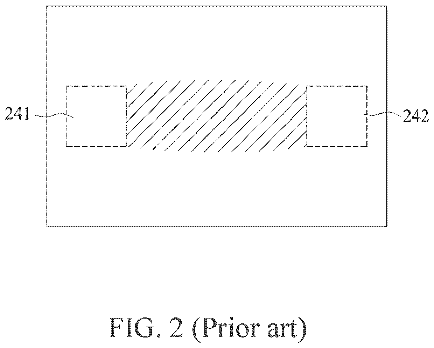

FIG. 2 is a top view of the surface facing towards the transparent substrate 250 and the current conduction layer 240 in FIG. 1. The dashed rectangle on the left corresponds to the projected position 241 of the P-metal electrode 210 set in FIG. 1, while the dashed rectangle on the right corresponds to the projected position 242 of the N-metal electrode 220 set in FIG. 1. As shown in FIG. 1 and FIG. 2, when the P-metal electrode 210 and the N-metal electrode 220 are conducted, the current transmission paths almost all conduct in a straight line between the projected position 241 of the P-metal electrode 210 and the projected position 242 of the N-metal electrode 220. Thus, a longitudinally shaped surface light source will diverge as shown in FIG. 2. Even if the overall shape design of the emitting surface is changed or the area of the emitting surface is increased, the current will still conduct along the shortest path and the same longitudinally shaped surface light source will be formed so the luminous efficiency is unable to increase. Furthermore, since the current is concentrated in the straight-line conduction between the projected position 241 of the P-metal electrode 210 and the projected position 242 of the N-metal electrode 220, it will result in problems such as excessive heating, poor electrostatic discharge, or excessive leakage current due to excessively high current density.

Therefore, how to design a flip-chip light emitting diode and its manufacturing method that can improve the aforementioned problems is indeed a subject worthy of study.

### SUMMARY OF THE INVENTION

One objective of the present invention is to provide a method for manufacturing a flip-chip light emitting diode that increases the light emitting area and reduces the current density.

Another objective of the present invention is to provide a method for manufacturing a flip-chip light emitting diode that effectively improves the heat dissipation effect and anti-static capability.

To achieve the above objective, the present invention discloses a method for manufacturing a flip-chip light emitting diode, including the following steps: providing a first substrate; performing an epitaxial process to form a semiconductor structure on the first substrate, wherein the semiconductor structure includes a first semiconductor epitaxial layer, a light emitting layer, a second semiconductor epitaxial layer and a current conduction layer in sequence from adjacent to the first substrate, a bonding surface is formed by the current conductive layer and defines a first electrode projection area and a second electrode projection area; performing a diffusion process toward the bonding surface by a diffusion material to form at least one path area with a high doping concentration in the current conductive layer; performing a bonding process to bond a second substrate to the bonding surface; and removing the first substrate and forming a first electrode and a second electrode on a side of the semiconductor structure adjacent to the first substrate, wherein a position of the first electrode corresponds to the first electrode projection area, and a position of the second electrode corresponds to the second electrode projection area.

In one embodiment of the present invention, the at least one path area is disposed the other position located outside a shortest connection path between the first electrode projection area and the second electrode projection area.

In one embodiment of the present invention, the at least one path area is further disposed on a shortest connection path between the first electrode projection area and the second electrode projection area.

In one embodiment of the present invention, each of the at least one path area is in the form of a square area, a long strip area, a circular area, an elliptical area, a curved area, a grid-like pattern area, a dendritic pattern area or a radial pattern area.

In one embodiment of the present invention, the doping concentration of each of the at least one path area is 10 to 10³ times the doping concentration of other areas in the current conduction layer other than the at least one path area.

In one embodiment of the present invention, before performing the bonding process, at least one bonding material is coated to the bonding surface.

In one embodiment of the present invention, the diffusion material is selected from one of the following material groups consisting of beryllium, magnesium, zinc and iron.

In one embodiment of the present invention, the diffusion material is selected from the same type of material as the doping material of the current conduction layer.

In one embodiment of the present invention, the current conduction path formed by each of the at least one path area has a resistance within a set range.

The present invention further includes a flip-chip light emitting diode manufactured by the method for manufacturing a flip-chip light-emitting diode as described above.

By this design, the manufacturing method of the flip-chip light emitting diode according to the present invention forms at least one path area of high doping concentration at predetermined positions within the current conduction layer through performing diffusion processes. This allows the current to be more easily conducted through these path areas for preventing excessive concentration of current density, and thereby, increasing the emitting area and brightness of the produced flip-chip LED. Additionally, the flip-chip LED produced by the manufacturing method of the present invention can enhance heat dissipation and electrostatic discharge resistance.

### BRIEF DESCRIPTION OF THE DRAWINGS

FIG. 1 shows a schematic diagram of a conventional flip-chip light emitting diode (LED).
FIG. 2 shows a schematic diagram of a conventional flip-chip LED as shown in FIG. 1 in the illuminated state.
FIG. 3 depicts a flowchart of the manufacturing method for the flip-chip LED according to the present invention.
FIG. 4 illustrates a schematic diagram of the manufactured structure corresponding to each step in the manufacturing method of the flip-chip LED according to the present invention.
FIG. 5A illustrates a schematic diagram of a first embodiment of at least one path area planned according to the present invention.
FIG. 5B illustrates a schematic diagram of a second embodiment of at least one path area planned according to the present invention.
FIG. 5C illustrates a schematic diagram of a third embodiment of at least one path area planned according to the present invention.
FIG. 6 shows a schematic diagram of the structure of a flip-chip LED manufactured using the manufacturing method of the present invention.

### DETAILED DESCRIPTION OF THE PREFERRED EMBODIMENT

Since various aspects and embodiments are only illustrative and non-restrictive, after reading this description, a person with ordinary knowledge may also have other aspects and embodiments without departing from the scope of the present invention. According to the following detailed description and patent application scope, the features and advantages of these embodiments will be more clearly demonstrated.

In this document, "one" or "a" is used to describe the components and assemblies disclosed herein. This is done merely for convenience of explanation and to provide a general sense of scope of the present invention. Therefore, unless clearly stated otherwise, such descriptions should be understood to encompass one or more, and the singular also includes the plural.

In this document, terms such as "first" or "second" and similar ordinal numbers are primarily used to distinguish or refer to the same or similar components or structures without necessarily implying an order in space or time. It should be understood that in certain situations or configurations, ordinal numbers can be used interchangeably without affecting the implementation of the present invention.

In this document, the terms "comprising," "having," or any other similar terms are intended to encompass non-exclusively inclusive matter. For example, a component or structure containing multiple elements is not limited to only those elements listed in this document, but may include other elements that are generally inherent to the component or structure but not explicitly listed.

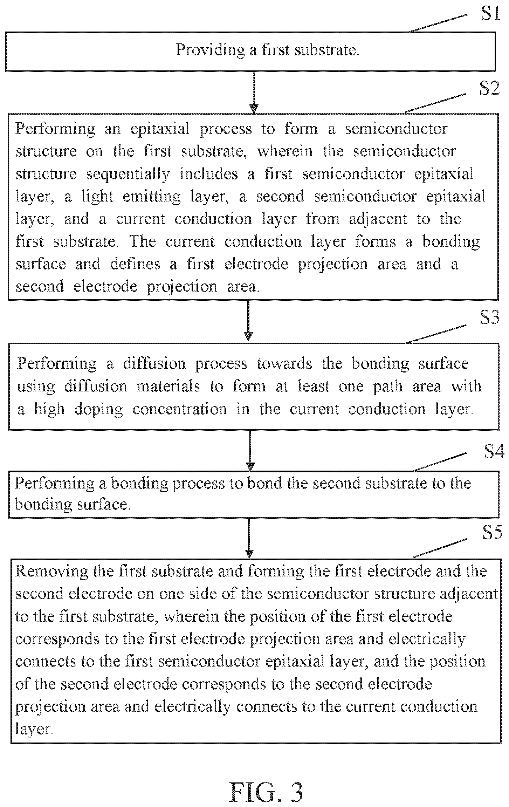

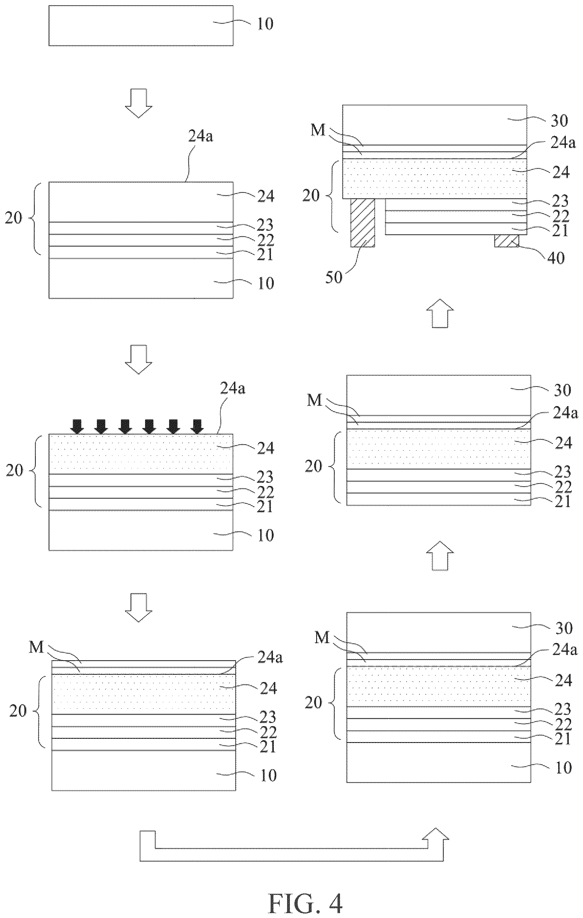

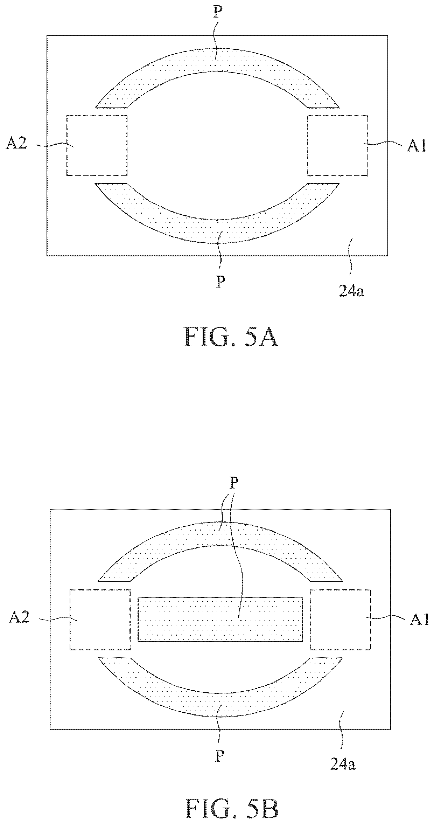

Please refer to FIG. 3 to FIG. 5A collectively. FIG. 3 is a flowchart illustrating the process of manufacturing the flip-chip light emitting diode according to the present invention. FIG. 4 is a schematic diagram showing the corresponding fabricated structures of each step in the manufacturing method of the flip-chip light emitting diode according to the present invention. FIG. 5A is a schematic diagram of at least one path area in a first embodiment planned according to the present invention. As shown in FIG. 3 to FIG. 5A, the manufacturing method of the flip-chip light emitting diode according to the present invention includes the following steps:

Step S1: Providing a first substrate.

First, the present invention provides a first substrate 10 as a temporary substrate for the flip-chip light emitting diode 1 of the present invention for carrying other components of the flip-chip light emitting diode 1. The first substrate 10 has a flat structure. In one embodiment of the present invention, the first substrate 10 is a gallium arsenide (GaAs) substrate, but the first substrate 10 may also be made of other semiconductor materials or commonly used substrate materials, and the present invention is not limited thereto.

Step S2: Performing an epitaxial process to form a semiconductor structure on the first substrate, wherein the semiconductor structure sequentially includes a first semiconductor epitaxial layer, a light emitting layer, a second semiconductor epitaxial layer, and a current conduction layer from adjacent to the first substrate. The current conduction layer forms a bonding surface and defines a first electrode projection area and a second electrode projection area.

Following the step S1 of providing the first substrate 10, the present invention proceeds to perform an epitaxial process on the first substrate 10 to form a semiconductor structure 20. The semiconductor structure 20 is sequentially stacked on the first substrate 10 through the epitaxial process, comprising a first semiconductor epitaxial layer 21, a second semiconductor epitaxial layer 23, and a current conduction layer 24. A light emitting layer 22 is formed between the first semiconductor epitaxial layer 21 and the second semiconductor epitaxial layer 23, primarily providing light emission after conduction. In one embodiment of the present invention, the first semiconductor epitaxial layer 21 is made of N-type semiconductor material, such as N-type aluminum gallium indium phosphide (AlGaInP), the light emitting layer 22 is a multiple-quantum well (MQW) layer, the second semiconductor epitaxial layer 23 is made of P-type semiconductor material, such as P-type aluminum gallium indium phosphide (AlGaInP), and the current conduction layer 24 is made of P-type gallium phosphide (GaP) (e.g., doped with magnesium (Mg) element). However, the materials of each layer in the semiconductor structure 20 are not limited to the aforementioned materials.

Since the current conduction layer 24 is stacked on the top of the semiconductor structure 20, the current conduction layer 24 forms an exposed and large-area bonding surface 24a. In the subsequent manufacturing process, it is necessary to form a first electrode 40 and a second electrode 50 on the surface of one side of the semiconductor structure 20 adjacent to the first substrate 10. Therefore, a first electrode projection area A1 is formed on the bonding surface 24a of the current conduction layer 24. The first electrode projection area A1 is an area where the first electrode 40 is to be formed sequentially thereon and is projected onto the bonding surface 24a along a straight line direction perpendicular to the surface of that side. Similarly, a second electrode projection area A2 is formed on the bonding surface 24a of the current conduction layer 24. The second electrode projection area A2 is an area where the second electrode 50 is to be formed sequentially thereon and is projected onto the bonding surface 24a along a straight line direction perpendicular to the surface of that side. In one embodiment of the present invention, due to the cross-sections of the first electrode 40 and the second electrode 50 along the parallel bonding surface 24a are rectangular, the first electrode projection area A1 and the second electrode projection area A2 will be rectangular accordingly. However, the present invention is not limited thereto.

Step S3: Performing a diffusion process towards the bonding surface using diffusion materials to form at least one path area with a high doping concentration in the current conduction layer.

After the semiconductor structure 20 be formed in the preceding step S2, the present invention proceeds to perform a diffusion process on the current conduction layer 24. The diffusion process primarily utilizes diffusion materials to diffuse towards the bonding surface 24a of the current conduction layer 24. This allows the diffusion material to permeate through the bonding surface 24a and be doped into the current conduction layer 24 for altering the doping concentration of the current conduction layer 24. The aforementioned diffusion materials are selected from materials of the same type as the doping material of the current conduction layer 24. In one embodiment of the present invention, since the material of the current conduction layer 24 is P-type gallium phosphide (GaP), the diffusion material is selected from one of the following material groups: beryllium (Be), magnesium (Mg), zinc (Zn), and iron (Fe). However, other commonly used P-type diffusion materials may also be performed.

In the present invention, before performing the diffusion process, the areas of the current conduction layer 24 where a change in doping concentration is desired can be planned. This allows, after executing the diffusion process, at least one path area P within the current conduction layer 24 with a high doping concentration to be formed. Each path area P can be regarded as a three-dimensional electrical conduction pathway. Since the majority of the conduction current in a conventional flip-chip light emitting diode is concentrated at the linear connection between the two electrodes, the aforementioned at least one path area P can be planned to be located at positions other than the shortest connection path between the first electrode projection area A1 and the second electrode projection area A2 (i.e., on the sides of the aforementioned shortest connection path). In other words, the at least one path area P is planned at positions where the conduction current in the conventional flip-chip light emitting diode is less likely to pass through for thereby improving the problem of excessive concentration of conduction current in the conventional flip-chip light emitting diode. Since each path area P has a high doping concentration to reduce the impedance of the original material, each path area P can form a path for easier current conduction for allowing the conduction current to pass through. In one embodiment of the present invention, the doping concentration of each path area P is 10 to 10³ times that of the doping concentration in areas other than at least one path area P in the current conduction layer 24. The doping concentration of each path area P is greater than 1E+18 atoms/cm³.

Each path area P can vary its path length and shape according to different design requirements. In one embodiment of the present invention, each path area P may be in the form of a square area, a long strip area, a circular area, an elliptical area, a curved area, a grid-like pattern area, a dendritic pattern area, or a radial pattern area. In FIG. 5A, the path area P is illustrated as a curved area, but the present invention is not limited thereto.

Additionally, in terms of design, each current conduction path formed by each path area P has a resistance value within a predetermined range. In other words, in this invention, the resistance value formed by any path area P is kept similar to that formed by another path area P, both designed within the same set range of resistance values. As a result, the resistance values of any two path areas P do not differ too much for allowing the current to conduct through these path areas P more effectively, achieving better current dispersion, and preventing the current from concentrating too much on any one path area P.

Taking FIG. 5A as an example, at least one path area P comprises two curved areas, each positioned on either side of the shortest connecting path between the first electrode projection area A1 and the second electrode projection area A2. In conventional designs, because the shortest connecting path between the first electrode projection area A1 and the second electrode projection area A2 is shorter, the paths on either side are longer with higher resistance values, thus causing the current to preferentially flow through the shortest path. This invention establishes these path areas P through diffusion processes for ensuring that each path area P has a resistance value within a predetermined range (for example, within the same or a similar range as the resistance value of the shortest path mentioned above). Therefore, when the current flows, it spreads through these path areas P and the aforementioned shortest path for thereby increasing the area through which the current flows, and increasing the light emitting area, and brightness thereof.

Please refer to FIG. 5B for a schematic diagram of a second embodiment of at least one path area planned in the present invention. As shown in FIG. 5B, in this embodiment, if the resistance values of these path areas P located on either side of the shortest path are significantly lower than the resistance value of the shortest path, at least one path area P can be positioned on the shortest connecting path between the first electrode projection area A1 and the second electrode projection area A2. This arrangement ensures that the resistance values of these path areas P approach or are similar to the resistance value of the aforementioned shortest path.

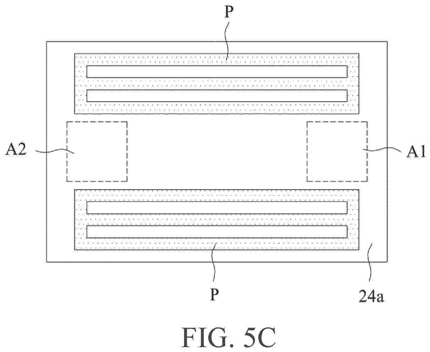

Please refer to FIG. 5C for a schematic diagram of a third embodiment of at least one path area planned in the present invention. As shown in FIG. 5C, in this embodiment, each path area P is in the form of a grid-like area, allowing the distribution range of each path area P to cover as much of the entire area of the current conduction layer 24 as possible. This enables the current to pass through a larger area, thereby increasing the luminous area.

Step S4: Performing a bonding process to bond the second substrate to the bonding surface.

After the diffusion process in the preceding step S3, the present invention proceeds to perform a bonding process on the semiconductor structure 20. This process involves covering and bonding the second substrate 30 onto the bonding surface 24a of the current conduction layer 24 to complete the bonding of the second substrate 30 and the semiconductor structure 20. In one embodiment of the present invention, the second substrate 30 is made of sapphire substrate, but it can also be made of other materials with transparent characteristics. This invention is not limited thereto.

To facilitate the second substrate 30 smoothly bonding to the bonding surface 24a of the current conduction layer 24, in one embodiment of the present invention, before performing the bonding process, at least one bonding material M may be applied to the bonding surface 24a. The at least one bonding material M is a viscous gel-like material. For example, the at least one bonding material M can be a stacked coating of, but not limited to, silicon dioxide (SiO₂) and aluminum oxide (Al₂O₃).

Step S5: Removing the first substrate and forming the first electrode and the second electrode on one side of the semiconductor structure adjacent to the first substrate, wherein the position of the first electrode corresponds to the first electrode projection area and electrically connects to the first semiconductor epitaxial layer, and the position of the second electrode corresponds to the second electrode projection area and electrically connects to the current conduction layer.

After performing the bonding process in the aforementioned step S4, the present invention removes the first substrate 10 adjacent to the semiconductor structure 20. Subsequently, etching and electrode formation processes are conducted on one side of the semiconductor structure 20 originally adjacent to the first substrate 10 to form the first electrode 40 and the second electrode 50 on the semiconductor structure 20. The first electrode 40 electrically connects to the first semiconductor epitaxial layer 21, and its position corresponds to the aforementioned first electrode projection area A1. The second electrode 50 electrically connects to the current conduction layer 24, and its position corresponds to the aforementioned second electrode projection area A2. In one embodiment of the present invention, the first electrode 40 is an N-metal electrode, and the second electrode 50 is a P-metal electrode. Since the structural arrangement of the first electrode 40 and the second electrode 50 follows a common design for conventional flip-chip light emitting diodes, further description is skipped.

Accordingly, by performing the manufacturing method of the flip-chip light emitting diode (LED) according to the present invention, the flip-chip LED 1 of the present invention can be produced. When a power supply is provided to the first electrode 40 and the second electrode 50 of the flip-chip LED 1 of the present invention, the current can pass through at least one path area P planned in the current conduction layer 24 via the second electrode 50, and thereby, pass through the light-emitting layer 22 to emit light, and finally reach the first electrode 40. The light emitted from the light-emitting layer 22 is emitted from the second substrate 30. As the current can be routed through positions that were originally less conductive (such as the edge areas closer to the bonding surface 24a) after planning these path areas P, the overall light-emitting area of the flip-chip LED 1 of the present invention can be increased. This leads to a more uniform distribution of current throughout the entire current conduction layer 24, reducing current density, and enhancing heat dissipation and electrostatic discharge capability.

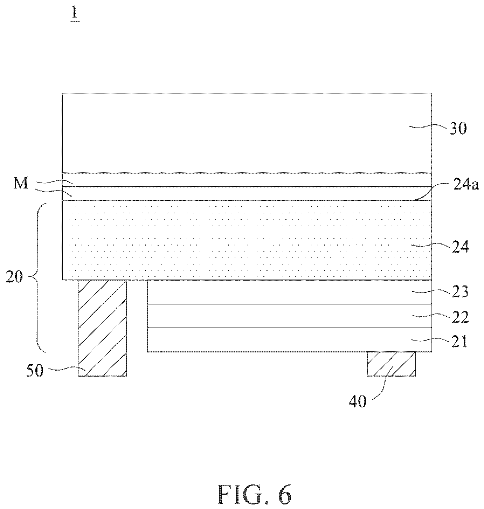

Please refer to FIG. 3 to FIG. 6, where FIG. 6 is a schematic diagram of the flip-chip LED produced using the manufacturing method of the flip-chip LED according to the present invention. As shown in FIG. 3 to FIG. 6, the present invention further includes a flip-chip LED 1 manufactured using the aforementioned manufacturing method of the flip-chip LED. The flip-chip LED 1 of the present invention is formed with at least one path area P in the current conduction layer 24 during the manufacturing process by means of a diffusion process. Since detailed descriptions have been provided for the various structural components and their functions of the flip-chip LED 1 according to the present invention in the preceding steps, further explanation is skipped here.

The above embodiments are essentially for illustrative purposes only and are not intended to limit the embodiments of the claims or the applications or uses thereof. Furthermore, although at least one exemplary embodiment has been presented in the foregoing embodiments, it should be understood that the present invention may have numerous variations. It should also be understood that the embodiments described herein are not intended to limit the scope, applications, or configurations of the claimed subject matter in any way. On the contrary, the foregoing embodiments may provide a convenient guide for those skilled in the art to implement one or more embodiments disclosed herein. Additionally, various changes may be made to the functions and arrangements of the components without departing from the scope defined by the claims, and the claims encompass all known equivalents and foreseeable equivalents at the time of filing of the present patent application.

## Claims

1. A method for manufacturing a flip-chip light emitting diode, including the following steps:
providing a first substrate;
performing an epitaxial process to form a semiconductor structure on the first substrate, wherein the semiconductor structure includes a first semiconductor epitaxial layer, a light emitting layer, a second semiconductor epitaxial layer and a current conduction layer in sequence from adjacent to the first substrate, a bonding surface is formed by the current conductive layer and defines a first electrode projection area and a second electrode projection area;
performing a diffusion process toward the bonding surface by a diffusion material to form at least one path area with a high doping concentration in the current conductive layer;
performing a bonding process to bond a second substrate to the bonding surface; and
removing the first substrate and forming a first electrode and a second electrode on a side of the semiconductor structure adjacent to the first substrate, wherein a position of the first electrode corresponds to the first electrode projection area, and a position of the second electrode corresponds to the second electrode projection area.

2. The method for manufacturing a flip-chip light emitting diode of claim 1, wherein the at least one path area is disposed the other position located outside a shortest connection path between the first electrode projection area and the second electrode projection area.

3. The method for manufacturing a flip-chip light emitting diode of claim 2, wherein the at least one path area is further disposed on a shortest connection path between the first electrode projection area and the second electrode projection area.

4. The method for manufacturing a flip-chip light emitting diode of claim 1, wherein each of the at least one path area is in the form of a square area, a long strip area, a circular area, an elliptical area, a curved area, a grid-like pattern area, a dendritic pattern area or a radial pattern area.

5. The method for manufacturing a flip-chip light emitting diode of claim 1, wherein the doping concentration of each of the at least one path area is 10 to 10³ times the doping concentration of other areas in the current conduction layer other than the at least one path area.

6. The method for manufacturing a flip-chip light emitting diode of claim 1, wherein before performing the bonding process, at least one bonding material is coated to the bonding surface.

7. The method for manufacturing a flip-chip light emitting diode of claim 1, wherein the diffusion material is selected from one of the following material groups consisting of beryllium, magnesium, zinc and iron.

8. The method for manufacturing a flip-chip light emitting diode of claim 1, wherein the diffusion material is selected from the same type of material as the doping material of the current conduction layer.

9. The method for manufacturing a flip-chip light emitting diode of claim 1, wherein the current conduction path formed by each of the at least one path area has a resistance within a set range.

10. A flip-chip light emitting diode manufactured by the method for manufacturing a flip-chip light-emitting diode as described in any one of claims 1 to 9.
